# EUROPEAN PATENT APPLICATION

(11) **EP 2 450 967 A1**
(43) Date of publication of application: **09.05.2012**
(21) Application number: 11752954.5
(22) Date of filing: 05.01.2011
(51) Int. Cl.: H01L 31/042

(54) **SOLAR CELL MODULE AND METHOD FOR REINFORCING SOLAR CELL MODULE**

(30) Priority: 08.03.2010 JP 2010051034
(71) Applicant: Fuji Electric Co., Ltd., Kawasaki-shi Kanagawa 210-9530 (JP)
(72) Inventor: TSUKAHARA, Yuji, Kanagawa 210-9530 (JP)
(74) Representative: Appelt, Christian W.
(86) International application number: PCT/JP2011/000011
(87) International publication number: WO 2011/111286

(57) **Abstract**

A photovoltaic module includes a photovoltaic device cell (10), a protective member (100), a penetration hole (120), and reinforcement members (202, 204). The protective member (100) seals the entire part of the photovoltaic device cell (10) and has flexibility. The penetration hole (120) is provided in the protective member (100), and is positioned between the edge of the protective member (100) and the photovoltaic device cell (10). The reinforcement members (202, 204) are attached to the protective member (100), and at least part thereof is positioned between the penetration hole (120) and the edge of the protective member (100).

## Description

### TECHNICAL FIELD

The present invention relates to a photovoltaic module and a method of reinforcing the photovoltaic module.

### BACKGROUND ART

Recently, a campaign concerning the environment has been widely spread, and a photovoltaic device has come into wide use with the campaign. In order to use the photovoltaic device, a photovoltaic module having a photovoltaic device cell needs to be fixed to a support member.

For example, in the disclosure of Patent Literatures 1 and 2, a penetration hole is formed in a protective member protecting a photovoltaic device cell, and a string passes through the penetration hole to fix the photovoltaic module.

Further, in the disclosure of Patent Literature 3, an end portion of a flexible photovoltaic module passes through a ring to bend so that the photovoltaic module can be fixed.

Further, in the disclosure of Patent Literatures 4 and 5, a photovoltaic device cell is protected by a resinous layer or a flexible sheet, a reinforcement member is attached to the resinous layer or the flexible sheet, and then a penetration hole is provided in the reinforcement member and the resinous layer or the flexible sheet.

Furthermore, the structure of protecting the photovoltaic device cell by the flexible sheet and attaching the reinforcement member to the flexible sheet is also disclosed in Patent Literature 6.

### CITATION LIST

### PATENT LITERATURE

Patent Literature 1: Japanese Patent Application Laid-Open No. 2006-339684
Patent Literature 2: Japanese Patent Application Laid-Open No. H06-13635
Patent Literature 3: Japanese Patent Application Laid-Open No. 2006-339683
Patent Literature 4: Japanese Patent Application Laid-Open No. 2006-74068
Patent Literature 5: Japanese Patent Application Laid-Open No. 2002-141542
Patent Literature 6: Japanese Patent Application Laid-Open No. 2005-136242

### DISCLOSURE OF INVENTION

### PROBLEM TO BE SOLVED BY THE INVENTION

In the case where the protective member protecting the photovoltaic device cell is formed of a flexible material, when the protective member is provided with a penetration hole through which a string passes, a crack or the like may be formed in the protective member by a force in which the string or the like supports the protective member. In order to prevent this, as disclosed in Patent Literatures 4 and 5, the penetration hole may be provided at a portion where the reinforcement member and the protective member overlap each other. However, when a structure is adopted in which the penetration hole is formed in the reinforcement member, the penetration hole needs to be provided in both the reinforcement member and the protective member.

In order to ensure the reliability of the protective member, it is desirable that the penetration hole of the protective member be formed in a factory. For this reason, when a structure is adopted in which the penetration hole is provided in both the reinforcement member and the protective member, if precision is considered, it is desirable that the reinforcement member be attached in advance in a factory or the like and the penetration hole be also formed in the factory. However, when this method is adopted, it is difficult to carry the photovoltaic module.

The invention is made in view of such circumstances, and an object thereof is to provide a photovoltaic module that needs not provide a penetration hole in a reinforcement member and may suppress a crack or the like from being formed in a protective member, and a method of reinforcing the photovoltaic module.

### MEANS FOR SOLVING PROBLEM

A photovoltaic module according to the invention includes a photovoltaic device cell, a protective member, and a reinforcement member. The protective member has flexibility and seals the entire part of photovoltaic device cell. A penetration hole is provided in the protective member. The penetration hole is positioned between the edge of the protective member and the photovoltaic device cell. The reinforcement member is attached to the protective member, and at least part thereof is positioned between the penetration hole and the edge of the protective member. Furthermore, the reinforcement member may be attached onto the protective member, or may be attached to the protective member in a manner of being sealed by the protective member.

In many cases, a force may be applied to a portion of the side surface of the penetration hole, near the edge of the protective member. For this reason, when the protective member cracks to start from the penetration hole, the crack occurs from a portion of the side surface of the penetration hole, near the edge of the protective film. In this regard, in the invention, the reinforcement member is positioned between the penetration hole and the edge of the protective member. Therefore, it is possible to suppress an occurrence of a crack starting from the penetration hole in the protective member. Further, since the penetration hole does not overlap the reinforcement member, it is not necessary to form the penetration hole in the reinforcement member.

According to the invention, the following method of reinforcing the photovoltaic module is provided. The photovoltaic module corresponding to a reinforcement subject includes a photovoltaic device cell and a protective member. The protective member has flexibility and seals the entire part of the photovoltaic device cell. The penetration hole is provided in the protective member. The penetration hole is positioned between the edge of the protective member and the photovoltaic module. Then, the reinforcement member is provided in the protective member such that at least part thereof is positioned between the penetration hole and the edge of the protective member.

### EFFECT OF THE INVENTION

According to the invention, the penetration hole may not be provided in the reinforcement member, and a crack or the like may be prevented from being formed in the protective member.

### BRIEF DESCRIPTION OF DRAWINGS

The above-described object, other objects, features, and advantages will be more apparent from the embodiments described below and the accompanying drawings thereof:

FIG. 1 is a perspective view of a photovoltaic module according to a first embodiment.
FIG. 2(a) is a cross-sectional view taken along the line A-A' of FIG. 1, and FIG. 2(b) is a cross-sectional view illustrating a modified example of FIG. 2(a).
FIG. 3 is a perspective view illustrating a first example of a method of fixing the photovoltaic module shown in FIG. 1.
FIG. 4 is a plan view illustrating a second example of a method of fixing the photovoltaic module shown in FIG. 1.
FIG. 5 is a plan view illustrating a third example of a method of fixing the photovoltaic module shown in FIG. 1.
FIG. 6 is a perspective view illustrating a configuration of a photovoltaic module according to a second embodiment.
FIG. 7 is a plan view illustrating a configuration of a photovoltaic module according to a third embodiment.
FIG. 8 is a cross-sectional view taken along the line A-A' of FIG. 7.
FIG. 9 is a plan view illustrating a modification of FIG. 7.
FIG. 10 is a plan view illustrating a configuration of a photovoltaic module according to a fourth embodiment.

### BEST MODE(S) FOR CARRYING OUT THE INVENTION

Hereinafter, embodiments of the invention will be described with reference to the drawings. Furthermore, in all drawings, the same reference numerals are given to the same components, and the description thereof will not be redundantly repeated.

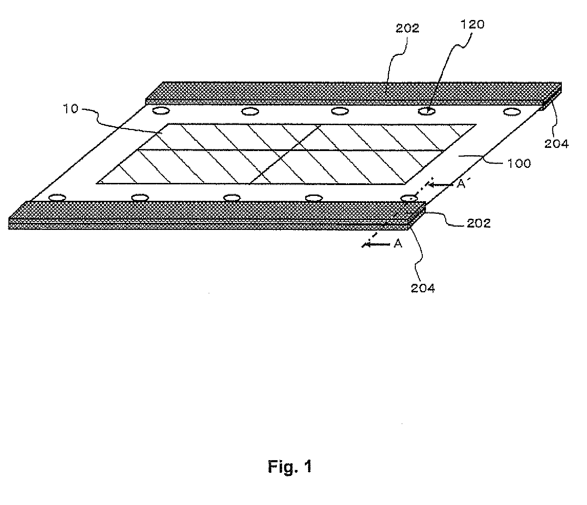

FIG. 1 is a perspective view of a photovoltaic module according to a first embodiment. The photovoltaic module includes photovoltaic device cells 10, a protective member 100, penetration holes 120, and reinforcement members 202 and 204. The protective member 100 seals the entire part of the photovoltaic device cell 10 and has flexibility. The penetration holes 120 are provided in the protective member 100, and are positioned between the edge of the protective member 100 and the photovoltaic device cells 10. The reinforcement members 202 and 204 are attached to the protective member 100, and at least a part thereof is positioned between the penetration holes 120 and the edge of the protective member 100. Hereinafter, this will be described in detail.

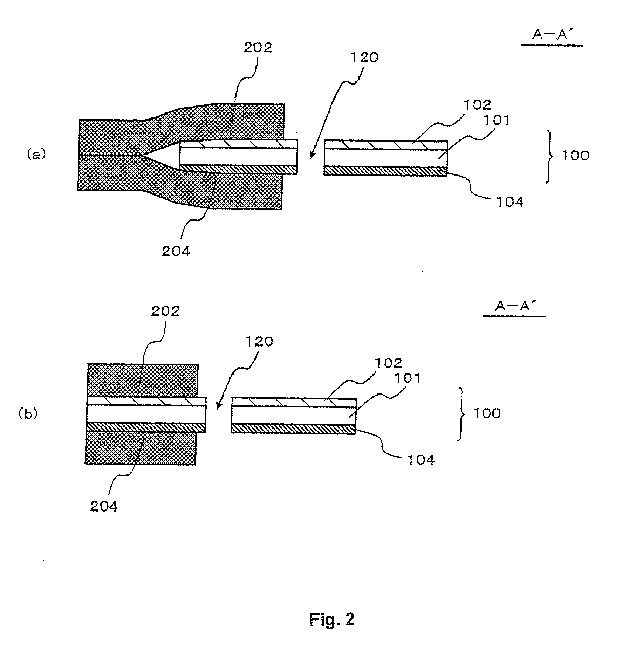

In the embodiment, since the photovoltaic device cell 10 is formed by using a flexible substrate, it has flexibility. Furthermore, for example, the protective member 100 is formed by attaching a front surface protection material 102 (shown in FIG. 2) and a rear surface protection material 104 (shown in FIG. 2) to a sealing resin 101 (shown in FIG. 2), and seals the photovoltaic device cells 10. As a method of sealing the photovoltaic device cells 10, for example, a vacuum lamination method or a roll lamination method is used.

The front surface protection material 102 is, for example, a film formed of a tetrafluoroethylene-ethylene copolymer, a fluoroethylene resin, a trifluorochloroethylene resin, an acrylic resin, a trifluorochloroethylene resin coating acrylic resin, or a polyester resin.

The sealing resin 101 is a laminated film and is, for example, a film of a resin material, such as an ethylene-vinyl acetate copolymer (hereinafter, referred to as EVA), an epoxy resin, a urethane resin, a silicon resin, an acrylic resin, a fluorine resin, or polyisobutylene. Furthermore, since the sealing resin 101 has a certain degree of adhesiveness, moisture may not intrude into the sealing resin 101 from the side surface of the penetration hole 120.

The rear surface protection material 104 is, for example, a film formed of an aluminum foil laminate mono-fluorinated vinyl resin, an aluminum foil laminate polyester resin, a tetrafluoroethylene-ethylene copolymer, a fluoroethylene resin, a trifluorochloroethylene resin, an acrylic resin, a trifluorochloroethylene resin coating acrylic resin, or a polyester resin.

Furthermore, as the front surface protection material 102, for example, Ethylene tetrafluoroethylene (ETFE) may be used, and as the rear surface protection material 104, for example, Polyethylene terephthalate (PET) or Polyethylene naphthalate (PEN) may be used.

The reinforcement members 202 and 204 are formed of a material having strength higher than that of the protective member 100, that is, a material strong against shearing. The reinforcement members 202 and 204 are formed of, for example, metal such as aluminum, reinforced plastic, or Fiber Reinforced Plastics (FRB). The reinforcement member 202 is positioned in the front surface of the protective member 100, and the reinforcement member 204 is positioned in the rear surface of the protective member 100.

Furthermore, in the example shown in FIG. 1, the plurality of photovoltaic device cells 10 are provided. Then, the sealing resin of the protective member 100 seals a wire, which electrically connects the respective photovoltaic device cells 10 to each other, together with the photovoltaic device cells 10.

In the embodiment, the photovoltaic device cell 10 and the protective member 100 all have a rectangular shape in the plan view. The plurality of penetration holes 120 are provided at the same interval along each of two opposite sides in the protective member 100. Furthermore, the reinforcement members 202 and 204 are provided along each of the above-described two sides of the protective member 100. For this reason, the reinforcement members 202 and 204 are positioned between each of the plurality of penetration holes 120 and the edge of the protective member 100.

FIG. 2(a) is a cross-sectional view taken along the line A-A' of FIG. 1. As described above, the protective member 100 is formed by attaching the front surface protection material 102 and the rear surface protection material 104 to the sealing resin 101. The reinforcement member 202 is positioned on the front surface protection material 102, and the reinforcement member 204 is positioned on the rear surface protection material 104. A structure is configured such that the reinforcement member 202 and the reinforcement member 204 face each other and the protective member 100 is interposed therebetween. Furthermore, the ends of the reinforcement members 202 and 204 protrude from the protective member 100 in the plan view, and are in contact with each other at the protruding portions. The reinforcement members 202 and 204 may be fixed to each other at the portion protruding from the protective member 100 using a rivet or a screw or may be fixed to each other using an adhesive. Furthermore, in the case of using the adhesive, it is desirable that the reinforcement member 202 adhere to the front surface protection material 102 and the reinforcement member 204 adhere to even the rear surface protection material 104.

However, as shown in FIG. 2(b), the ends of the reinforcement members 202 and 204 may not protrude from the protective member 100. In the example shown in the figure, the ends of the reinforcement members 202 and 204 are flush with the end of the protective member 100.

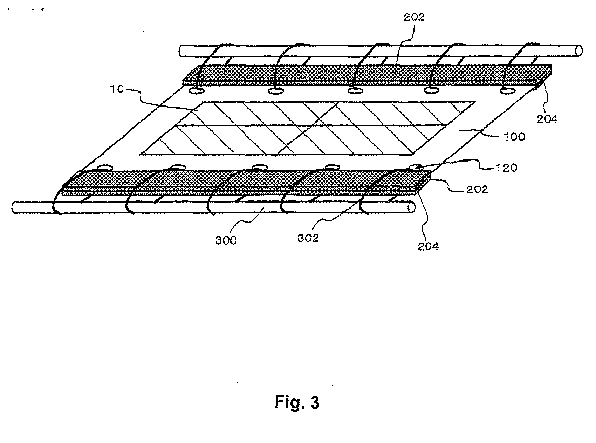

FIG. 3 is a perspective view illustrating a first example of a method of fixing the photovoltaic module shown in FIG. 1. In the example shown in the drawing, the photovoltaic module is connected to a bar-shaped or pipe-shaped support member 300 by using a linear fixation member 302 such as string or wire. The fixation member 302 passes through the penetration hole 120 and is then connected to the support member 300. Furthermore, the penetration hole may be provided even in the support member 300. In this case, the fixation member 302 also passes through the penetration hole of the support member 300.

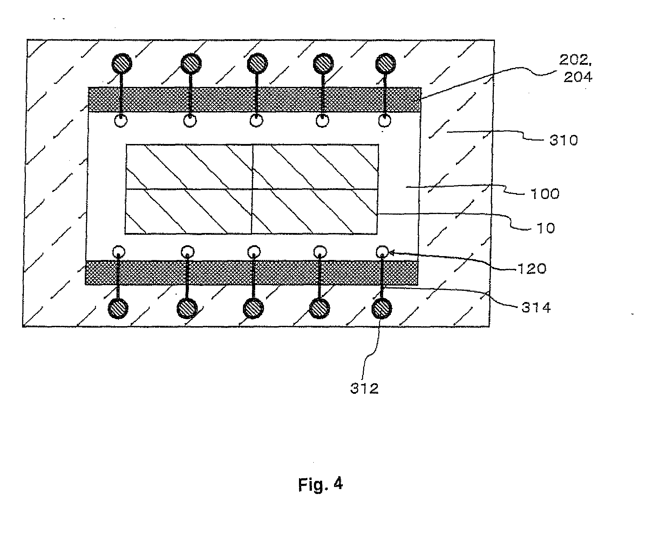

FIG. 4 is a plan view illustrating a second example of a method of fixing the photovoltaic module shown in FIG. 1. In the example shown in the drawing, the photovoltaic module is fixed to a planar support member 310. The support member 310 is, for example, a roof or a wall surface, and is provided with a plurality of convex members 312, for example, screws or pins. The plurality of convex members 312 are provided at positions along two sides, provided with the penetration holes 120, of the photovoltaic module around the attachment area of the photovoltaic module.

Then, each convex member 312 is coupled to a linear fixation member 314 such as string or wire. The fixation member 314 passes through the penetration hole 120 and is then coupled to the convex member 312.

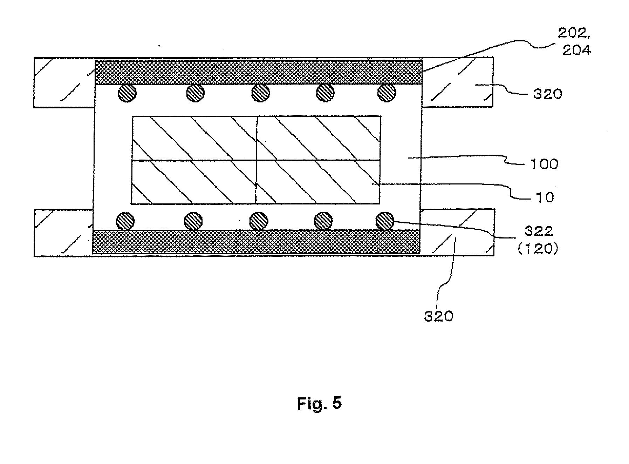

FIG. 5 is a plan view illustrating a third example of a method of fixing the photovoltaic module shown in FIG. 1. In the example shown in the drawing, the photovoltaic module is fixed to a frame 320 by using a screw 322. Specifically, the frame 320 is disposed at a position where the frame 320 overlaps the penetration hole 120. Then, when the screw 322 passes through the penetration hole 120 and is then screwed into the frame 320, the photovoltaic module is fixed to the frame 320.

Next, the operation and the effect of the embodiment will be described. In the case of adopting the fixation structures shown in FIGS. 3 to 5, when a force is applied to the photovoltaic module, the force is transferred to the fixation members 302 and 314, or the screw 322 through the edge of the penetration hole 120. At this time, the fixation members 302 and 314 or the screw 322 abuts on the portion, near the edge of the protective member 100, of the edge of the penetration hole 120. Therefore, when the protective member 100 cracks, starting from the penetration hole 120, the crack occurs from the portion, near the edge of the protective member 100, of the edge of the penetration hole 120.

Meanwhile, in the embodiment, the reinforcement members 202 and 204 are positioned between the penetration hole 120 and the edge of the protective member 100. For this reason, it is possible to suppress an occurrence or development of a crack in the protective member 100.

Further, since the penetration hole 120 does not overlap the reinforcement members 202 and 204, there is no need to form the penetration hole in the reinforcement members 202 and 204.

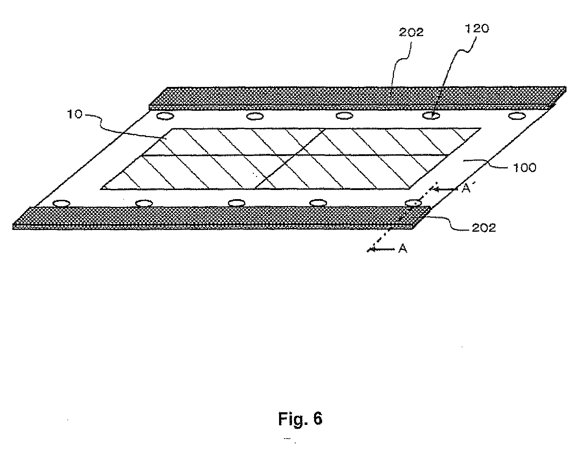

FIG. 6 is a perspective view illustrating a configuration of a photovoltaic module according to a second embodiment. The photovoltaic module according to the embodiment has the same configuration as that of the photovoltaic module according to the first embodiment except for the following points.

First, this photovoltaic module does not include the reinforcement member 204. Furthermore, the reinforcement member 202 is attached to the front surface protection material 102 of the protective member 100.

Even in the embodiment, the same effect as that of the first embodiment may be obtained.

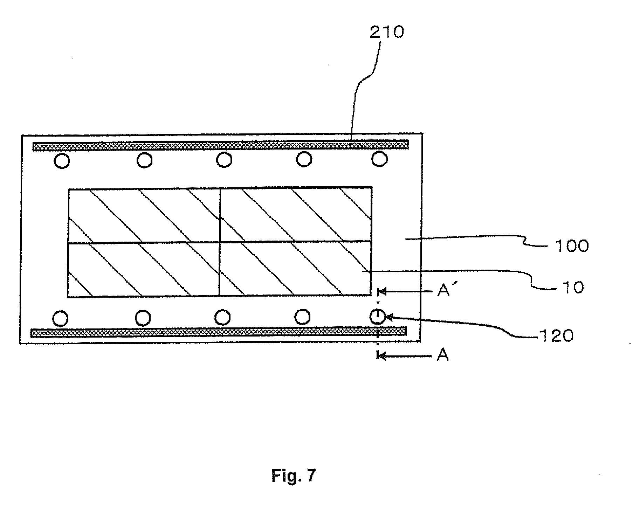

FIG. 7 is a plan view illustrating a configuration of a photovoltaic module according to a third embodiment. The photovoltaic module according to the embodiment has the same configuration as that of the photovoltaic module according to the first embodiment except that it includes a reinforcement member 210 instead of the reinforcement members 202 and 204.

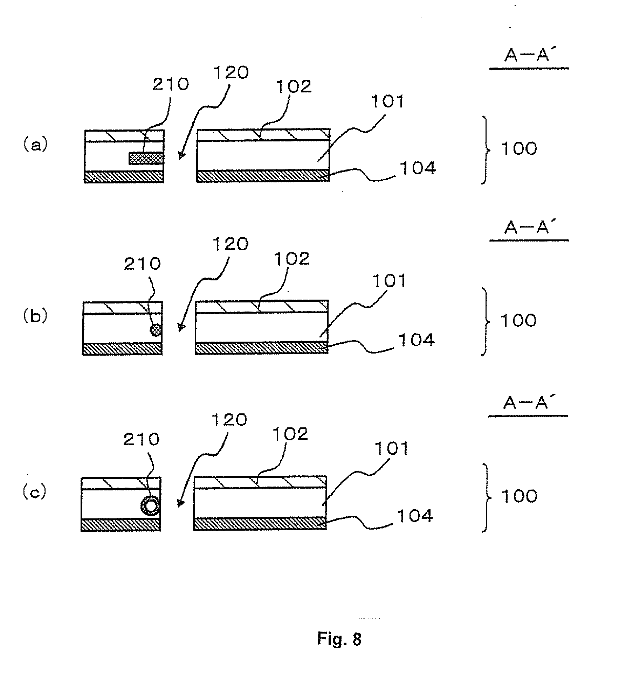

FIG. 8 is a cross-sectional view taken along the line A-A' of FIG. 7. As shown in the drawing, the reinforcement member 210 is sealed by the sealing resin 101 of the protective member 100. That is, the reinforcement member 210 is sealed through lamination of the sealing resin 101 together with the photovoltaic device cell 10.

The reinforcement member 210 may have a plate shape as shown in FIG. 8(a), that is, a rectangular cross-section or a bar shape as shown in FIG. 8(b), that is, a circular or oval cross-section. Further, the cross-section of the reinforcement member 210 may be formed in a circular or rectangular pipe shape as shown in FIG. 8(c). Furthermore, in any case, it is desirable that the side surface of the reinforcement member 210 be positioned near the side surface of the penetration hole 120.

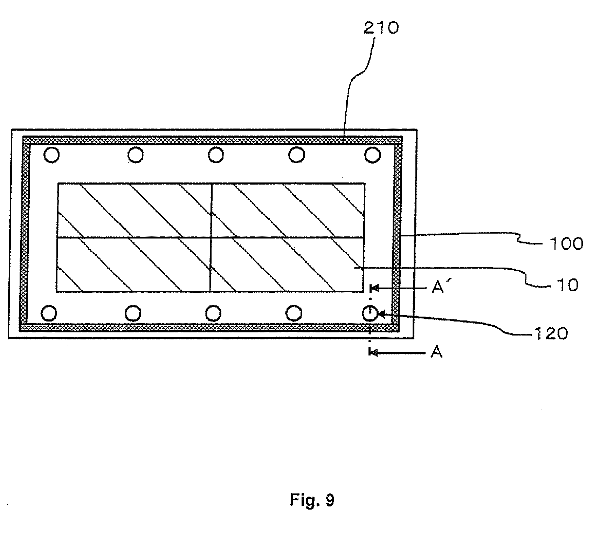

Furthermore, as shown in FIG. 9, the reinforcement member 210 may be provided along each of four sides of the protective member 100. In this case, it is desirable that the reinforcement member 210 have a closed shape.

Even in the embodiment, the same effect as that of the first embodiment may be obtained. Further, since the reinforcement member 210 is sealed by the sealing resin 101, the contact area between the reinforcement member 210 and the protective member 100 becomes larger. Accordingly, since a force exerted through the penetration hole 120 may be transferred to be dispersed in the protective member 100, the reinforcement member 210 may be suppressed from being detached from the protective member 100.

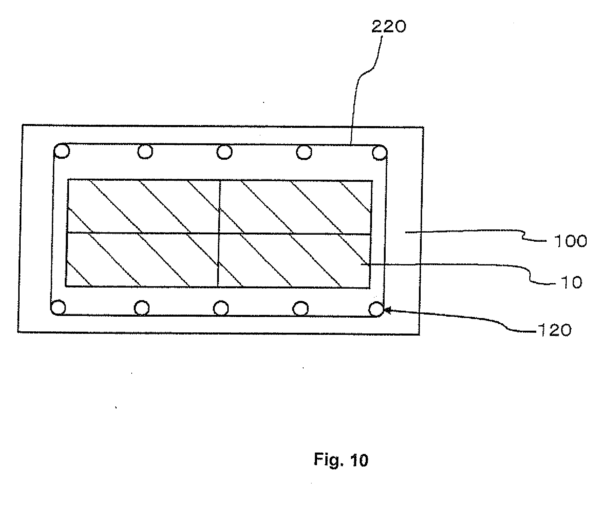

FIG. 10 is a plan view illustrating a configuration of a photovoltaic module according to a fourth embodiment. The photovoltaic module according to the embodiment has the same configuration as that of the photovoltaic module according to the third embodiment except that a wire 220 is used instead of the reinforcement member 210. The wire 220 is provided along each of four sides of the protective member 100, and has a closed shape.

Even in the embodiment, the same effect as that of the third embodiment may be obtained.

While the embodiments of the invention have been described by referring to the drawings, theses are examples of the invention, and various configurations may be adopted instead of the above-described configuration. For example, in the first and second embodiments, the reinforcement members 202 and 204 may be provided for all of four edges of the protective member 100.

Priority is claimed on Japanese Patent Application No. 2010-051034, filed on March 8, 2010, the entire content of which is incorporated herein by reference.

## Claims

1. A photovoltaic module comprising:
a photovoltaic device cell;
a protective member that seals the entire part of the photovoltaic device cell and has flexibility;
a penetration hole that is provided in the protective member and is positioned between the edge of the protective member and the photovoltaic device cell; and
a reinforcement member which is attached to the protective member and of which at least a part is positioned between the penetration hole and the edge of the protective member.

2. The photovoltaic module according to claim 1,
wherein the photovoltaic device cell is formed by using a flexible substrate.

3. The photovoltaic module according to claim 1 or 2,
wherein the reinforcement member is formed of a material having strength higher than that of the protective member.

4. The photovoltaic module according to any one of claims 1 to 3,
wherein as the penetration, there are a plurality of the penetration holes, and
wherein the reinforcement member is positioned between each of the plurality of penetration holes and the edge of the protective member.

5. The photovoltaic module according to claim 4,
wherein the protective member has a rectangular shape,
wherein the plurality of penetration holes are provided along each of two opposite sides of the protective member, and
wherein the reinforcement member is provided along each of the two sides of the protective member.

6. The photovoltaic module according to claim 5,
wherein the reinforcement member is provided along each of four sides of the protective member and has a closed shape.

7. The photovoltaic module according to any one of claims 1 to 6,
wherein the reinforcement member is positioned on one surface of the protective member.

8. The photovoltaic module according to claim 7, further comprising:
a second reinforcement member that is positioned on the other surface of the protective member and faces the reinforcement member.

9. The photovoltaic module according to any one of claims 1 to 6,
wherein the reinforcement member is sealed by the protective member.

10. The photovoltaic module according to claim 9,
wherein the reinforcement member is a bar-shaped or pipe-shaped member.

11. The photovoltaic module according to claim 9,
wherein the reinforcement member is wire.

12. The photovoltaic module according to any one of claims 1 to 11, further comprising:
a support member; and
a fixation member that passes through the penetration hole and fixes the protective member to the support member.

13. A method of reinforcing a photovoltaic module including a photovoltaic device cell, a protective member sealing the entire part of the photovoltaic device cell and having flexibility, and a penetration hole provided between the edge of the protective member and the photovoltaic device cell in the protective member,
wherein a reinforcement member is provided in the protective member so that at least a part thereof is positioned between the penetration hole and the edge of the protective member.
